Europäisches Patentamt

European Patent Office

Office européen des brevets

(19)

(11) **EP 1 089 081 B1**

(12) **EUROPEAN PATENT SPECIFICATION**

(45) Date of publication and mention
of the grant of the patent:
**16.03.2005 Bulletin 2005/11**

(51) Int Cl.$^7$: **G01R 31/08**

(21) Application number: **00660163.7**

(22) Date of filing: **22.09.2000**

(54) **Method for computational determination of ground fault distance in an electrical power distribution network having a ring configuration**

Verfahren zum Berechnen der Entfernung von Fehlerstrom in einem elektrischen Stromversorgungsnetz mit ringformiger Gestaltung

Méthode de calcul de la distance du défaut à la terre dans un réseau de distribution d'énergie ayant une configuration en anneau

(84) Designated Contracting States:
**AT BE CH CY DE DK ES FI FR GB GR IE IT LI LU MC NL PT SE**

(30) Priority: **23.09.1999 FI 992045**

(43) Date of publication of application:
**04.04.2001 Bulletin 2001/14**

(73) Proprietor: **ABB Oy**
**00380 Helsinki (FI)**

(72) Inventor: **Nikander, Ari**
**33820 Tampere (FI)**

(74) Representative: **Lipsanen, Jari et al**
**Seppo Laine Oy,**
**Itämerenkatu 3 B**
**00180 Helsinki (FI)**

(56) References cited:
**US-A- 4 996 624**

• NIKANDER A ET AL: "Methods for earth fault identification and distance estimation in a compensated medium voltage distribution network" ENERGY MANAGEMENT AND POWER DELIVERY, 1998. PROCEEDINGS OF EMPD '98. 1998 INTERNATIONAL CONFERENCE ON SINGAPORE 3-5 MARCH 1998, NEW YORK, NY, USA,IEEE, US, 3 March 1998 (1998-03-03), pages 595-600, XP010293689 ISBN: 0-7803-4495-2

• WILLIS O L: "A review of fault locating techniques in medium-voltage power cable" PETROLEUM AND CHEMICAL INDUSTRY CONFERENCE, 1991, RECORD OF CONFERENCE PAPERS., INDUSTRY APPLICATIONS SOCIETY 38TH ANNUAL TORONTO, ONT., CANADA 9-11 SEPT. 1991, NEW YORK, NY, USA,IEEE, US, 9 September 1991 (1991-09-09), pages 225-228, XP010053152 ISBN: 0-7803-0193-5

EP 1 089 081 B1

**EP 1 089 081 B1**

**Description**

The invention relates to a method according to claim 1 for computational determination of ground fault distance in an electric power transmission network connected into a ring configuration utilizing the information available, e.g., from the numerical measurement data obtained by means of a multifunction relay.

Conventionally, ground faults are located by means of test connections. After the faulted sending end has been found, the line is divided with the help of a disconnector in two sections. Next, the sending end is energized and the zero voltage is employed for detecting on which side about the disconnector the fault is to be found. This procedure is repeated along the line until the faulted section between two disconnectors is identified. Typically, the fault along the section must be inspected by walking in the terrain. In an underground cable network, the final location of the fault must be made using, e.g., acoustic methods (such as a cable locator) or bridge measurements. Other suitable techniques known in the art are the surge-wave method and the high-frequency method.

The publication [Nik98] describes a method for indication and location of earth faults in a compensated medium voltage network and presents algorithms for determining the total phase-to-earth admittance and unbalance of the medium voltage distribution system and each of its MV feeder.

The method provides information on earth fault distance which can be obtained by rearranging the faulted feeder, normally operated radially, into a closed ring over some healthy feeder where the fault distance along both feeders can be determined by using two different values of the zero sequence voltage and corresponding zero sequence currents of the feeders.

Computational methods developed for locating ground fault distance in an isolated neutral network and a compensated network of the resonant-ground-type are based on the detection of the transient phenomenon occurring at the start instant of a ground fault [Leh92]. When a ground fault commences, the current of the faulted phase of the faulted sending end shows a transient comprised of the line charge and discharge components. More specifically, the charge transient is caused by the charging of capacitances of the sound phase legs, while the discharge transient is generated by the discharge of capacitances of the faulted phase. The computation of the fault distance utilizes the charging transient as it is the dominating component in the overall transient waveform due to its lower frequency and slower attenuation. These transient analysis methods, of which different variants have been disclosed, are based on the solution of the differential equation set of a mathematical model wherefrom the inductance of the line section between the distribution station and the fault location can be determined by way of analyzing the measured current and voltage transient waveforms of the faulted phase.

In publication [Win93] is described a method based on connecting the faulted line at its sending end into a ring configuration, whereupon the tuning of the inverter used for compensation of residual current is changed. Then, a current is passed via the fault. The location of the fault can be determined from the proportional distribution of the fault current.

A drawback of such test configurations is that they have been found slow and cumbersome to use in the determination of the fault distance. This is because only a limited number of the test connections can be set up by means of remote-controlled disconnectors. Hence, a major portion of the required connections must be configured with the help of manually-controlled disconnectors, which requires the operating personnel to cover large distances along the ground. During the fault location procedure, the disconnector must be reclosed possibly several times under the fault situation. This burdens the network with overvoltages containing waveform components both at the operating frequency and the higher frequencies of the switching transients that put a stress on the insulation of the network and may in certain cases lead to a secondary fault even more severe than that initially being identified.

Transient analysis methods are based on the determination of the inductance of the line section between the fault and the distribution station. When this inductance is converted into the line length to the fault, the zero-sequence inductance must be determined by computational techniques. Computation of the zero-sequence inductance is inaccurate for an underground cable. This causes error in the location of the fault. To be functional, these methods always require information on the positive-, negative and zero-sequence inductances of the line, and also information on the connection status of the line. Hence, there must exist a data communications facility established between the overlying control system and the relay equipment.

One of the most serious drawbacks of transient analysis methods is that the transients of the initial fault situation attenuate very rapidly with larger fault resistances. Resultingly, these methods cannot be used when the ground fault resistance exceeds 50 to 200 ohms. The transient waveforms of the initial fault situation are also affected by factors that cannot be taken into account, such as the frequency-dependent characteristics of loads. Also the load situation affects the attenuation of transients.

An advantage of transient analysis methods is that they can be used in a radially configured network thus dispensing with the need for changes in the network connections.

A disadvantage of the method disclosed in cited publication [Win93] is that it needs the compensation of the ground fault current with costly star-point inverter equipment. Furthermore, the system does not provide any possibility of utilizing the network data in the fault location, but instead, only gives the proportional distribution of the fault current as a percentage ratio. Hence, the accuracy of the system in fault location is inferior in most cases. A benefit of the method is that it appears to be functional at substantially higher fault resistance values than the transient analysis methods can manage. A fault can be located only along a bulk power transfer section.

It is an object of the present invention to overcome the problems of the prior-art techniques and to provide an entirely novel type of method for computational detennination of ground fault distance in an electric power transmission network connected into a ring configuration utilizing the information available, e.g., from the numerical measurement data obtained by means of a multifunction relay.

The goal of the invention is achieved by virtue of measuring the neutral voltage of the network, the line-to-neutral voltages, the neutral currents at the sending ends of the lines in the ring configuration and one line-to-line voltage for phasor synchronization. After the measurements, the ring configuration is opened, the signals are referenced to the phase of the line-to-line voltage and the frequency components different from the fundamental frequency component are filtered away, whereupon the RMS values are computed using the fundamental-frequency components of the signals and the distance to the fault is computed, whereupon the faulted line section can be disconnected.

More specifically, the method according to the invention is characterized by what is stated in the characterizing part of claim 1.

The invention provides significant benefits.

Medium-voltage networks are generally operated having the sending ends configured in a radial manner, although the networks are often arranged in loops to assure continuity of service. When a ground fault occurs in the network so that one phase conductor becomes conducting to ground, the neutral voltage of the network rises due to the unsymmetry invoked by the fault. Hence, the neutral voltage can be used for fault indication. The directional relay of each sending line end measures in an isolated-neutral network the reactive component of the neutral current and, in a damped network, the real component of the current. Accordingly, a faulted sending end can be detected from the direction and magnitude of these current components. For high-impedance faults, methods to be described later in more detail can be utilized.

On a faulted line, the faulted circuit is looped via the line-to-ground capacitances of the line conductors. Then, the line-to-ground capacitances, the fault resistance and, in a resonant-ground system, the inductance of the arc-suppression reactor determine the magnitude of the fault current. As the longitudinal impedance of the line section between the fault point and the distribution station in practice is insignificantly small as compared with the other impedances of the fault circuit, the fault distance does not contribute to the magnitude of the fault current. Resultingly, the fault distance cannot be computed from the fault current as is possible in short-circuit faults, but instead other methods must be used.

The length of the faulted line from the sending end may be tens of kilometers, in some cases even more than 100 km. The distance to a ground fault can be computed by looping the faulted sending end with one of the sound sending ends, which generally is possible. This kind of computational determination of the distance between the fault point and the distribution station offers significant time savings in the fault identification and reduces the disturbance caused by the fault inasmuch no test connections need to be configured. Computational determination of a ground fault also reduces the need to dispatch personnel to the terrain which is in most cases necessary when test connections are configured using manually controlled disconnectors.

In addition to speeding up the configuration of test connections, the invention can give a significant time saving in the location of a ground fault persisting on a faulted sending end. Moreover, the method dispenses with switching operations (closure of a circuit breaker against a fault) that cause extra load on the network.

As compared with transient analysis methods, the invention offers an essential benefit by being capable of determining the fault distance at fault resistance values of even two decades higher than was possible in the prior art. Methods developed in the invention are suited for fault distance determination up to fault resistances of several tens of kiloohms (even up to 200 kohm). For instance, fallen trees typically cause a fault with an initially very high fault resistance that gradually becomes smaller with time. Now the fault can be located before the fault resistance drops so small that the line must be switched nonoperative. Also the unknown factors occurring in the measurement and origin of the transient waveform can be avoided, because the computational method according to the invention uses only fundamental-frequency components of voltages and currents. Furthermore, prior-art methods based on the analysis of transients occurring during the initial stage of a ground fault invariably utilize network data. Herein, the determination of zero-sequence impedance for underground cables is inaccurate by computational means. This limits the use of transient analysis methods chiefly to overhead line networks. In contrast, the methods according to the invention can be applied to, e.g., overhead lines for the computation of ground fault distance without resorting to network data. Hence, the present method is very simple to implement.

As compared with the method disclosed in cited publication [Win93], the present method offers two benefits. Firstly, the methods according to the invention can be applied to a resonant-ground and isolated-neutral system without the need for expensive inverter equipment. Also compensation of the ground fault current is not mandatory to the function of the invention. There is no need to install new equipment to the network. Moreover, the possibility of performing computations in the network operation support system environment facilitates the utilization of network data for higher accuracy in the fault location. This facility is inaccessible to the equipment disclosed in cited publication [Win93].

In regard to its overall costs, the present method is advantageous as it does not need investments in new measurement systems or equipment. The method can be implemented by software added to the network operation support system that communicates with the network control system and thus can retrieve the required measurement data therefrom.

The measurement data needed in the method comprise one neutral voltage, line-to-neutral voltages, one line-to-line voltage and sum currents of the looped sending ends. All of these measurement values are available at any distribution station. The line-to-line voltage is needed only in order to get a reference phase for the other variables, whereby the computed variables can be manipulated in phasor format.

Summarizing the advantage of the invention, it is appreciated that its implementation dispenses with the need for new equipment constructions and measurements, but instead its computational algorithms can be carried out on software compatible with existing data processing systems and numeric multifunction relays. The computation task may be accomplished in the network operation support system environment. This gives an opportunity to utilize network data.

In the following, the invention will be described in more detail with the help of an exemplifying embodiment illustrated in the appended drawings, wherein

FIG. 1 shows a flow diagram of an embodiment of a fault detection method for high-resistance ground faults; and

FIG. 2 shows diagrammatically an operating environment for the invention.

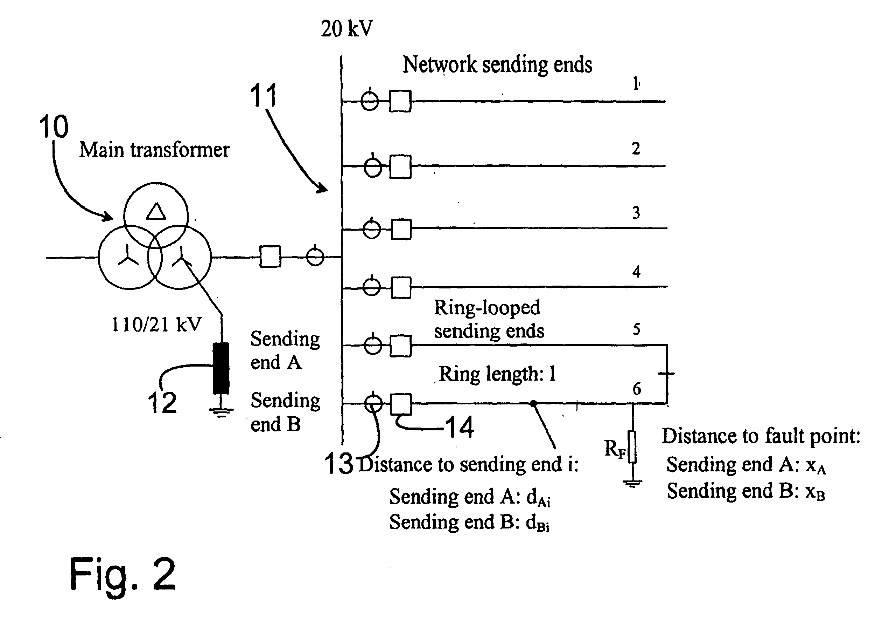

Referring to FIG. 2, the distance of a ground fault can be determined by connecting the faulted sending end into a looped ring configuration with some sound sending end of the same distribution station. In the following, four different methods are described suited for computation of the distance between the distribution station and the fault point. All of the methods are characterized in that they utilize the measurement values of the network neutral voltage and the sum currents of the sending ends looped into a ring configuration.

The steps of the entire fault location process are next examined in the operating environment shown in FIG. 2, where a main transformer 10 feeds a medium-voltage network 11. To the neutral of the transformer 10 is connected, if necessary, an arc-suppression reactor 12 that also is known in the art as the Petersen coil. The arc-suppression reactor may also be connected to the network via a grounding transformer. The actual medium-voltage network is fed by, e.g., sending ends 1 - 6. It must be noted herein that the illustrated number of six sending ends is nonlimiting to the invention that can be adapted to any number of sending ends. Each sending end is provided with a sum current measurement means 13 and a circuit breaker 14.

Step 1

The fault is detected and the faulted sending end 6 is determined with the help of the neutral current and voltage measurement (using a directional relay) or, in the case of high-impedance ground faults, by way of methods to be described later.

Step 2

The fault resistance is computed by way of methods (Eqs. 5 and 8) to be described later. As known, the fault resistance may also be computed with the help of the short-circuit ground fault equivalent circuit based on the Thévenin's theorem. Using these tools, the fault resistance can be computed when the network's neutral voltage, line-to-line voltage, summed line-to-ground capacitance and the inductance of the possible arc-suppression reactor are known.

Step 3

When the maximum time to fault location (that is, disconnector control time + measurement time) is known and the fault resistance has been computed, the conditions for safe touch voltage can be verified in advance.

Step 4

The faulted sending end 6 is looped into a ring configuration with one of the sound sending ends 5 by means of a disconnector. Even if a remote-controlled disconnector is not available, looping with a manually controlled disconnector speeds up the fault location operation in a great number of cases. If fault distance determination in an operative status is prohibited by the touch voltage regulations, the fault location may be determined in the same manner as is performed in test connections. Herein, the faulted sending end is allowed to trip in a normal manner and the looped ring configuration is established only momentarily for the measurements. Even so, the present method speeds up clearing the fault.

Step 5

The neutral voltage, line-to-neutral voltages and neutral currents of the ring-looped sending ends are measured, plus one line-to-line voltage to obtain a phase reference for phasor synchronization. After the measurements the ring arrangement is opened, whereby the faulted sending end may also trip. If the network can be operated for a certain time with a pending ground fault, the faulted line section can be disconnected directly without a need for tripping the entire line fed by the sending end.

Step 6

The measured signals are synchronized to the measured line-to-line voltage and the signals are filtered to remove frequency components different from the fundamental frequency waveform. The RMS values are computed using the fundamental-frequency components of the measurement signals.

Step 7

The fault distance is computed (using any of the 4 different methods available), whereupon the faulted line section can be disconnected.

The detection of a high-resistance ground fault is outlined next as follows:

Chiefly due to the unsymmetry of line-to-ground capacitances in a network, a small neutral voltage always occurs even under normal conditions in a network grounded via a large reactance (resonant-ground system) or in an isolated-neutral network. In a resonant-ground network, the neutral voltage can be altered by changing the tuning of the arc-suppression reactor. A change in the connection status also causes a change in the neutral voltage in both a resonant-ground and an isolated-neutral network. The neutral voltage under a normal condition may also be changed by means of an artificially generated capacitance unsymmetry. Herein, a capacitor is connected to one phase leg of the network, whereby the neutral voltage of an operative network rises. Also current injection to the neutral of the network can be used for changing the neutral voltage. This can be implemented in a relatively simple manner by connecting a 230 V voltage to an auxiliary winding (500 V) or measurement winding of the arc-suppression reactor. The current injection system can be isolated from the low-voltage circuit with the help of a suitable isolation transformer. A capacitor can be used for current limiting. The injection current may be smaller than 1 A and the duration of current injection need not be longer than a few seconds. These techniques are well known in the art. The inventiveness of the present invention is appreciated in the application of the measured neutral voltage change.

When the neutral voltage of the network changes, also the zero-sequence currents of the sending ends change. The line-to-ground admittance of the sending end can be computed with the help of the changes in the zero-sequence current and voltage. The following description defines the parameters and computational techniques needed in this computing procedure. Equations 1-4 used in the invention for computing the line-to-ground admittances and degree of network unsymmetry are known to those versed in the art. These equations are described in, e.g. cited publications [Lei97] and [Lei94]. The inventiveness of the present invention is based on the novel and continued development and application of these computational techniques into a network protection method utilizing the capabilities of a numerical multifunction relay without any need to provide additional information to the relay from higher-level automation systems of the network.

The definitions use the following subindexes:

$i$ =     sending end subindex, i = 1,2,3,...
$\nu$ =     phase subindex 1,2,3
$t$ =     sum of all the three phases
$E$ =     ground point
$U_1$=     line-to-neutral voltage
$\underline{a}$ =     -1/2 + j $\sqrt{3}/2$ (phase-shift operator)

The summed line-to-ground admittance of all the three phases is predominantly capacitive. Denoting the angular frequency corresponding to a nominal frequency of 50 Hz with symbol $\omega$ ($\omega = 2\pi f$), the line-to-ground admittance is

$$\underline{Y}_{tE} = \frac{1}{R_{tE}} + j\,\omega\,C_{tE} \tag{1}$$

According to the conventions of a resonant-ground network, the degree of network unsymmetry is defined as

$$\underline{k} = \frac{\underline{Y}_{1E} + \underline{a}^2\,\underline{Y}_{2E} + \underline{a}\underline{Y}_{3E}}{j\omega C_{tE}} \tag{2}$$

The degree of unsymmetry can be defined for both the entire network and a single sending end. For a single sending end, the admittances are the line-to-ground admittances for the sending end concerned.

The line-to-ground admittance of a sending end can be computed from the change of the zero-sequence current and voltage (Eq. 3). Herein, subindexes a and b refer to two separate measurements of the zero-sequence voltage and current. The zero-sequence voltage and current phasors are compared with such a reference phasor that does not change during a ground fault. Such an applicable reference phasor is one of the line-to-line voltages. The use of the change of the zero-sequence voltage and current in the computation of the line-to-ground admittance eliminates the effect of zero-sequence component due to the capacitance unsymmetry on the end result of the computation. For low-resistance ground faults, the sending-end line-to-ground admittances may also be computed directly from the zero-sequence current and voltage, because herein the capacitance unsymmetry effect is negligible. This is because the zero-sequence current component related to the capacitance unsymmetry is not dependent on the zero-sequence voltage, whereby

$$\underline{Y}_{tE} = \frac{\underline{I}_{0b} - \underline{I}_{0a}}{\underline{U}_{0b} - \underline{U}_{0a}} \tag{3}$$

Respectively, the degree of unsymmetry for the entire network or a single sending end can be computed from Eq. 4 written as

$$\underline{k} = \frac{\underline{I}_{0a} - \underline{Y}_{tE}\,\underline{U}_{0a}}{j\omega C_{tE}\,\underline{U}_t} \tag{4}$$

The basic concept of the invention is that the line-to-ground admittances and degrees of unsymmetry of the sending ends are computed each time the zero-sequence voltage of the network changes. In this manner it is assured that the line-to-ground admittances based on the measurement data obtained at the sending ends and the fault current values derived therefrom are at any time representative of instantaneous connection status of the network. The goal of the method is to indicate ground faults having a fault resistance in the range of 100 - 200 kohm. For ground fault resistances smaller than 10 kohm, the faulted sending end can be detected directly on the basis of the change in its line-to-ground admittance. Herein, the computation is supportive to the normal protection given by directional relays. The method is in the same manner applicable to an isolated-neutral network as to a resonant-ground network and does not need a change of the relay operating characteristics if the network-compensating reactor is disconnected from the network.

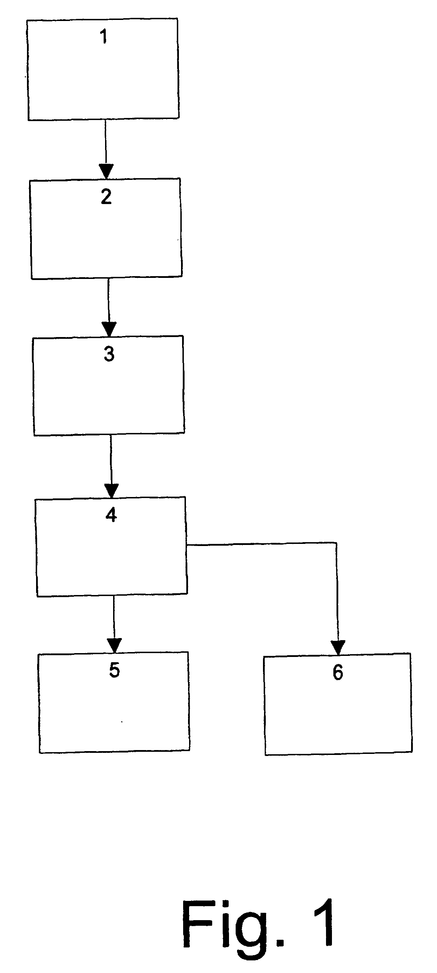

Now referring to FIG. 1, the steps are described elucidating the operation principles of the invention in the determination of the electrical length of a line, indication of high-impedance ground faults and determination of a faulted sending end:

Step 1

A reference value of the initial status (that is, the reference connection status, wherefrom computations begin) is computed for the line-to-ground admittance $Y_{tEi}$ of each sending end and for the degree of unsymmetry $|k_i|$, whereby an artificial shift of the neutral voltage or a change thereof caused by a switching status change or a ground fault is utilized for this purpose. Herein, the computation follows the techniques disclosed in cited publication [Lei97]. In the case of a resonant ground network, additional computations are made to determine the values of line-to-ground admittance and the degree of unsymmetry for the entire network utilizing for this purpose the zero-sequence current computed from the line-to-neutral currents of the sending end or, alternatively the zero-sequence current of the reactor branch if such a measurement value is available. The zero-sequence voltage is computed as a phasor sum of the line-to-neutral voltages or, alternatively, is measured from the open-delta winding of the voltage transformers. As the line-to-ground capacitance $C_{tE}$ in the computation of the degree of unsymmetry at each sending end is used a reference capacitance whose value is selected to be equal to the summed line-to-ground capacitance of all the three phase legs of the entire network in its reference connection state. The summed line-to-ground capacitance of the entire network can be computed from the zero-sequence current change of each sending end using Eqs. 1 and 3. The values of line-to-ground capacitance per sending end are required for determining the electrical length of the line and indication of high-impedance ground faults.

Step 2

As reference values are stored the values of line-to-ground admittance $Y_{tEiref}$ and $|k_{iref}|$ of each sending end denoted by subindex i. Also the normal-connection status values of the zero-sequence voltage, the zero-sequence currents of the sending ends and the zero-sequence current of the feeding power source are stored as reference values $U_{0ref}$, $I_{0refi}$ and $I_{0refs}$.

Step 3

When a change in the network connection status or a ground fault causes in the network a zero-sequence voltage change $\Delta U_0$ that exceeds a preset limit difference value $\Delta U_{0as}$, new values of line-to-ground admittance $Y_{tEi}$ and degree of unsymmetry $|k_i|$ are computed for each sending end. As a second set of reference values are stored the zero-sequence voltage and sending-end current values denoted as $U_{0ref}$, $I_{0refi}$. The zero-sequence current change at the faulted sending end is not used as such for fault indication, but instead the fault-situation zero-sequence voltage, sending-end zero-sequence current and precomputed value of the line-to-ground admittance are utilized for computing a parameter k which is representative to the unsymmetry of the sending end and whose change can be used for fault indication. The computation is performed simultaneously for each one of the sending ends, whereby the faulted sending end is found directly from the result of the computation and there is no need to identify the fault at the network level as is suggested in FI Pat. No. 100922 B. This approach gives higher sensitivity in fault location than what can be attained by detecting the fault merely from the change in the line-to-ground admittance of the faulted sending end.

Step 4

The computed line-to-ground admittance values of the sending ends are compared with the reference values $Y_{tEiref}$. If the sending-end line-to-ground admittance does not differ from the reference value $Y_{tEiref}$ by more than a preset error tolerance $\Delta Y_{tEi}$ caused by computational and measurement inaccuracy errors, the status of the sending end is assumed to be unchanged and the sending end obviously has no ground fault. In this case the stored reference value is not changed. If the deviation of the sending-end line-to-ground admittance value from the reference value $Y_{tEiref}$ is greater than $\Delta Y_{tEi}$, it is plausible to assume that the sending-end connection status has been changed or that the sending end is affected by a ground fault. A change in the connection status may also be inferred from the summed line-to-ground admittance change of the entire network, which is computed from the zero-sequence current of the feeding power source. However, this approach is applicable only when the change in the electrical line length exceeds the possible deviation due to measurement inaccuracy in the computed value of the entire network's admittance. When a change occurs in the connection status, new reference values are stored.

Step 5

The computed degrees of unsymmetry at the sending ends are compared with the stored reference values $|k_{iref}|$. If the computed degree of unsymmetry is greater than $|k_{iref}|$ and the change thereof is greater than $|\Delta k_i|$, it is plausible to assume that the sending end is affected by a high-impedance ground fault. The values of degree of unsymmetry can be computed from Eq. 4 without the need for a new shift of the zero-sequence voltage when the line-to-ground admittances of the sending ends are known in the prevailing connection state.

Step 6

An alternative method of monitoring the degree of unsymmetry is to monitor the ground-leakage resistances of the different phase legs at the sending ends. The monitoring of the leakage resistances may be arranged to take place in parallel with the monitoring of the degree of unsymmetry. If the degree of unsymmetry at any sending end changes, it is possible to infer from the leakage resistance $R_f$ whether a ground fault or a change in the connection status has occurred. This inference also gives such information on the faulted phase leg that may be utilized in the location of faults not identifiable by visual inspection. For instance, it is possible in conjunction with lightning arresters to determine which one of three phases has a defective arrester. Arc arresters are typically used for overvoltage protection of distribution stations and underground cables. The physical location of phase-leg conductors at distribution stations and underground cable terminations are generally identified. The leakage resistances of the different phases can be computed from Eq. 5 written as:

$$R_f = \frac{\underline{U}_v}{\underline{I}_{0i} + j\omega C_{tEi}\,\underline{U}_0} \tag{5}$$

where

$\underline{U}v =$      is voltage of phase $v$
$\underline{I}_{0i} =$      zero-sequence current $\underline{I}_0$ of sending end i
$\underline{C}_{tEi} =$      line-to-ground capacitance of sending end i in normal connection state
$\underline{U}_0 =$      zero-sequence voltage.

The zero-sequence current at the sending end comprises a zero-sequence-voltage-dependent component ($\underline{I}_{U0}$) and an unsymmetry-dependent component ($\underline{I}_k$) in accordance with Eq. 6 below. In practice, the line-to-ground capacitances per phase are not exactly equal.

$$\underline{I}_{0i} = \underline{I}_{U0} + \underline{I}_k = \underline{Y}_{tEi}\,\underline{U}_0 + (\underline{Y}_{01}\,\underline{U}_1 + \underline{Y}_{02}\,\underline{U}_2 + \underline{Y}_{03}\,\underline{U}_3) \tag{6}$$

where

$\underline{Y}_{tEi} =$      summed line-to-ground admittance of three phases at sending end i
$\underline{Y}_{01}, \underline{Y}_{02}, \underline{Y}_{03} =$      line-to-ground admittances of phases 1, 2 and 3
$\underline{U}_1, \underline{U}_2, \underline{U}_3 =$      symmetrical voltages of phases 1, 2 and 3.

The effect of the error caused by capacitance unsymmetry can be reduced in the following manner. After the zero-sequence susceptance $\underline{B}_{tE}$ at the sending end has been determined by the admittance computation, the capacitance-unsymmetry-dependent component of the zero-sequence current can be determined with the help of Eq. 6, whereupon its effect on the leakage resistance may thus be eliminated. Thus, the leakage resistances at each phase leg can be monitored on a continuous basis without allowing the capacitance unsymmetry to have any effect on the computational result. Changes in the zero-sequence voltage do not affect the capacitance-unsymmetry-dependent component of the zero-sequence current. In this manner, the status monitoring can be carried out on a continuous basis without a need for deviations to occur in the zero-sequence voltage. The unsymmetry-dependent component of the zero-sequence current may also be used as a direct fault indicator according to Eq. 6. As can be seen from the equation, a ground fault causes a change equal to the fault current in the unsymmetry-dependent component of the zero-sequence current.

$$I_{0Kfi} = I_{0i} - Y_{tEi}U_0 = \left(I_{0Ki} + \frac{U_{vF}}{R_F}\right) \tag{7}$$

where

$I_{0Ki} =$      unsymmetry-dependent current component of sending end i in a normal condition
$I_{0Kfi} =$      unsymmetry-dependent current component of sending end i in a fault condition.

When the zero-sequence voltage changes due to, e.g., a high-impedance fault ($R_f$ = 10 - 200 kohm), the fault resistance may also be determined from Eq. 8 [Lei97]. In this case, the computation is carried out replacing the absolute values of zero-sequence current and voltage by the changes of these variables:

$$R_f = \frac{\underline{U}_{vE}}{\Delta \underline{I}_{0i} - \underline{Y}_{tEi} \Delta \underline{U}_0} \tag{8}$$

where

$\underline{U}_{vE}$ = voltage of phase $v$ during a fault (high-impedance ground fault)

$\Delta \underline{I}_{0i}$ = (zero-sequence current $\underline{I}_0$ of sending end i during fault) - (zero-sequence current $\underline{I}_0$ of sending end i before fault)

$\underline{Y}_{0tot}$ = summed line-to-ground admittance of three phases of sending end i in a normal condition

$\Delta \underline{U}_0$ = change in zero-sequence voltage due to fault (= $\underline{U}_0$ during fault - $\underline{U}_0$ before fault)

Indication of a high-impedance fault and detection of a faulted sending end from the degree of unsymmetry or by means of Eqs. 5, 7 or 8 require the line-to-ground admittances of the sending ends to be known a priori for a situation prevailing before the fault. If the change in the zero-sequence voltage is caused by a ground fault, the line-to-ground admittances can be computed for all sound sending ends. In contrast, if the change in the zero-sequence voltage is caused by a change in the connection status, the line-to-ground admittances can be computed for all those sending ends that maintain their connection status unchanged. In the following is described a method for indication of a change in the connection status and determination of a new line-to-ground admittance value after a change in the connection state.

A change in the connection status of a sending end can be indicated and distinguished from a line fault with the help of the changes occurring in the zero-sequence voltage and current. The basic principle of the method is to measure at sending end i the zero-sequence voltage change $\Delta \underline{U}_0 = \underline{U}_{01} - U_{02}$ and, respectively, the zero-sequence current change $\Delta \underline{I}_{0i} = \underline{I}_{01} - \underline{I}_{02}$ that are detected from measurements 1 and 2. Herein, the sending-end line-to-ground admittance $\underline{Y}_{0i}$ is already known in the initial condition. The change in the sending-end line-to-ground admittance is denoted as $\Delta \underline{Y}_0$. When the zero-sequence voltage of the network changes, the zero-sequence current change at sending end i can be written as:

$$\Delta \underline{I}_{0i} = \underline{Y}_{0i} \, \underline{U}_{01} - (\underline{Y}_{0i} + \Delta \underline{Y}_0) \underline{U}_{02} \tag{9}$$

Herefrom, the change in line-to-ground admittance can be solved:

$$\Delta \underline{Y}_0 = \frac{\underline{Y}_{0i} \, \underline{U}_{01} - \Delta \underline{I}_{0i}}{\underline{U}_{02}} - \underline{Y}_{0i} \tag{10}$$

The formulation of Eq. 9 is based on the assumption that the zero-sequence current caused by the capacitance unsymmetry is not changed due to the change in the connection state. Eq. 9 is exactly valid for those sending ends on which the electrical line length does not change, that is, $\Delta \underline{Y}_0 = 0$. Hence, the detection of connection status change can be performed in a reliable manner. If the sending end has no change in its connection status nor a ground fault, the change $\Delta \underline{Y}_0$ in the line-to-ground admittance remains zero. Simultaneously, the method makes it possible to compute an estimate for the change in the electrical length of the line. Then, the line-to-ground admittance of the sending end can be corrected to a value corresponding to its new connection state. The ground fault detection is implemented by means of computing the leakage resistance per sending end with the help of Eqs. 5 and 8.

When the faulted sending end is looped into a ring configuration with some other sending end of the same distribution station, the line charge currents into the line-to-ground capacitances and the line-to-line capacitances are divided equally between the looped sending ends if the longitudinal impedances of the looped lines can be neglected. The charging current contribution of the line-to-ground capacitance of one phase leg is zero at the point of the ring configuration where the line-to-ground capacitance is divided half and half to both sides of the point. With an even distribution of the line-to-ground capacitances, this point is midway along the looped ring. Similarly, the charging current contributions from the line-to-line capacitances can be assumed to be divided half and half between the looped sending ends. In practice, the line impedances are unevenly distributed, particularly in mixed networks. This can be taken into account by way of a method to be described later.

The current component due to the fault resistance is divided in an inverse ratio according to the ratio of the impedances of the line sections running from the distribution station to the fault point. In the following examination, the line impedances are assumed to be evenly divided over the entire length of the line, whereby the line impedances can be directly replaced by the corresponding line lengths. Respectively, the line lengths may easily be replaced by the corresponding line impedances. The sending ends looped into a ring are denoted by indices A and B. Then, the line-charging currents of sending end A can be written into the following equations wherein the faulted phase is denoted by subindex 1. The leakage resistance have not been taken into account.

$$\underline{I}_{1A} = \frac{\underline{U}_{1F}}{R_F} \times \frac{x_B}{l} - \frac{j\omega C_{0r}}{2}\underline{U}_{1F} - \frac{\underline{U}_{1F}}{l}\sum_{i=1}^{n}(j\omega C_{0bi}d_{Bi}) - \frac{j\omega 3C_{kr}}{2}\underline{U}_{1p} \qquad (11)$$

$$\underline{I}_{2A} = -\frac{j\omega C_{0r}}{2}\underline{U}_{2F} - \frac{\underline{U}_{2F}}{l}\sum_{i=1}^{n}(j\omega C_{0bi}d_{Bi}) - \frac{j\omega 3C_{kr}}{2}\underline{U}_{2p} \qquad (12)$$

$$\underline{I}_{3A} = -\frac{j\omega C_{0r}}{2}\underline{U}_{3F} - \frac{\underline{U}_{3F}}{l}\sum_{i=1}^{n}(j\omega C_{0bi}d_{Bi}) - \frac{j\omega 3C_{kr}}{2}\underline{U}_{3p} \qquad (13)$$

where

| | |
|---|---|
| $\underline{U}_{1F}, \underline{U}_{2F}, \underline{U}_{3F} =$ | line-to-neutral voltages during fault |
| $\underline{U}_{1p}, \underline{U}_{2p}, \underline{U}_{3p} =$ | symmetrical phase voltages (positive-sequence components of phase voltages) |
| $C_{0r} =$ | summed line-to-ground capacitance of bulk power transmission section of looped ring per phase leg |
| $C_{0bi} =$ | line-to-ground capacitance per phase leg of lateral i connected to the bulk power transmission section |
| $C_{kr} =$ | summed line-to-line capacitances of the ring-looped lines |
| $R_F =$ | fault resistance |
| $X_A =$ | distance to fault point along line starting from sending end A |
| $X_B =$ | distance to fault point along line starting from sending end B |
| $d_{Ai} =$ | distance to fault point of lateral i along line of sending end A |
| $d_{Bi} =$ | distance to fault point of lateral i along line of sending end B |
| $l =$ | length of bulk power transmission section in the looped ring. |

Corresponding equations can be written for the line-charging currents of sending end B.

The fault distance can be computed by measuring the zero-sequence voltage, the voltage of the faulted phase and the sum currents of the ring-looped sending ends during fault. Then the following equations can be written with the help of Eqs. 11-13 for the sum currents of sending ends A and B. In these equations, the susceptances are replaced by the line-to-ground admittances in order to make it possible to handle the leakage conductances, too. The meaning of the subindexes are the same as in Eqs. 11-13. The capacitance unsymmetry contributes with its additional components to the sum currents of sending ends A and B. These components can be determined by way of a method to be described later. In the unfaulted status with $R_F = \infty$, the current components related to the fault resistance components of the sum currents and to the components dependent on the fault distance are zero.

$$\sum\underline{I}_{0A} = \underline{I}_{1A} + \underline{I}_{2A} + \underline{I}_{3A} = \frac{\underline{U}_{vF}}{R_F}\frac{x_B}{l} + \left(\frac{\underline{Y}_{0r}}{2} + \frac{1}{l}\sum_{i=1}^{n}(\underline{Y}_{0bi}d_{Bi})\right)\underline{U}_0 + \underline{I}_{0kA} \qquad (14)$$

$$\sum \underline{I}_{0B} = \underline{I}_{1B} + \underline{I}_{2B} + \underline{I}_{3B} = \frac{\underline{U}_{vF}}{R_F} \frac{x_A}{l} + \left( \frac{\underline{Y}_{0r}}{2} + \frac{1}{l} \sum_{i=1}^{n} (\underline{Y}_{0bi} d_{Ai}) \right) \underline{U}_0 + \underline{I}_{0kB} \qquad (15)$$

where

$\underline{U}_{vF} =$ line-to-neutral voltage of faulted phase leg

$\underline{I}_{0KA}, \underline{I}_{0KB} =$ capacitance-unsymmetry-related current components at sending ends A and B.

The operative part of the network comprising the sound sending ends not looped into the ring configuration and a possible arc-suppression reactor produces a fault current component $\Sigma I_{0b}$, whose magnitude is equal to the sum of the zero-sequence currents of the ring-looped sending ends. The fault resistance may also be determined from Eq. 16:

$$\Sigma \underline{I}_{0b} = \Sigma \underline{I}_{0A} + \Sigma \underline{I}_{0B} = \frac{\underline{U}_{vF}}{R_F} + \underline{Y}_{0c} \underline{U}_0 + \underline{I}_{0k} \qquad (16)$$

where

$Y_{0c} =$ summed line-to-ground admittance of the ring-looped sending ends including their laterals

$\underline{I}_{0k} =$ summed unsymmetry current of ring-looped sending ends.

The distance to fault point along either line of the ring-looped sending ends can be solved from Eqs. 14 and 15 as follows:

$$\frac{x_A}{l} = \left[ \underline{I}_{0B} - \left( \frac{\underline{Y}_{0r}}{2} + \frac{1}{l} \sum_{i=1}^{n} (\underline{Y}_{0bi} d_{Ai}) \right) \times \underline{U}_0 - \underline{I}_{0kB} \right] \times \frac{R_F}{\underline{U}_{vF}} \qquad (17)$$

$$\frac{x_B}{l} = \left[ \underline{I}_{0A} - \left( \frac{\underline{Y}_{0r}}{2} + \frac{1}{l} \sum_{i=1}^{n} (\underline{Y}_{0bi} d_{Bi}) \right) \times \underline{U}_0 - \underline{I}_{0kA} \right] \times \frac{R_F}{\underline{U}_{vF}} \qquad (18)$$

Herein, the bracket-enclosed terms of Eqs. 14 and 15 that represent the line-to-ground admittances are denoted as admittances $\underline{Y}_{0At}$ and $\underline{Y}_{0Bt}$. The admittances expressed below represent the effect of the bulk power line section of the looped ring with its laterals on the summed currents of the ring-looped sending ends:

$$\underline{Y}_{0At} = \left( \frac{\underline{Y}_{0r}}{2} + \frac{1}{l} \sum_{i=1}^{n} (\underline{Y}_{0bi} d_{Bi}) \right) \qquad (19)$$

$$\underline{Y}_{0Bt} = \left( \frac{\underline{Y}_{0r}}{2} + \frac{1}{l} \sum_{i=1}^{n} (\underline{Y}_{0bi} d_{Ai}) \right) \qquad (20)$$

The admittances $\underline{Y}_{0At}$ and $\underline{Y}_{0Bt}$ can be determined in two different ways. If the looped ring and its laterals comprise only overhead lines, it is plausible to assume that the charging currents of the line-to-ground capacitances are divided half and half between the sending ends A and B. In many cases, the effect of the laterals is so small that it may be neglected or, at most, only the laterals with the greatest electrical length need to be taken into account. Herein, it is necessary to utilize the network data. Then, the admittances are replaced by the corresponding susceptances. The contribution of unsymmetry current components is generally relatively small. However, their significance becomes manifest when ground faults of very high line-to-ground impedance must be located.

A more practical and exact method for determining the admittances $\underline{Y}_{0At}$ and $\underline{Y}_{0Bt}$ is to connect the sending ends A and B into a looped ring in an unfaulted state. First, the sum currents of the ring-looped sending ends are measured at two different levels of zero-sequence voltage. Then, the admittances $\underline{Y}_{0At}$ and $\underline{Y}_{0Bt}$ can be computed in preconfigured ring connections using Eqs. 21 and 22. Their validity remains unchanged as long as the ring connection to be used for fault location remains unchanged. Thus, these predetermined admittances can be directly used in the fault distance computation. At the same time, the uneven distribution of the line impedances and contribution of laterals will be automatically taken into account. The summed line-to-ground admittance of the entire looped ring configuration, the laterals inclusive, can be computed from Eq. 23. Being independent from the zero-sequence voltage, the unsymmetry current components do not affect the admittance values expressed as:

$$\underline{Y}_{0At} = \frac{\Delta \underline{I}_{0A}}{\Delta \underline{U}_0} \tag{21}$$

$$\underline{Y}_{0Bt} = \frac{\Delta \underline{I}_{0B}}{\Delta \underline{U}_0} \tag{22}$$

$$\underline{Y}_{0c} = \underline{Y}_{0At} + \underline{Y}_{0Bt} \tag{23}$$

If the neutral voltage of the network cannot be varied in the unfaulted state, the admittances $\underline{Y}_{0At}$ and $\underline{Y}_{0Bt}$ can be computed using the summed currents and zero-sequence voltage of the looped ring in its unfaulted status as the reference measurement values (Eqs. 24 and 25). Another possibility is to carry out a ground fault test or to use the summed currents and zero-sequence voltage of the looped ring measured under an actual ground fault as the reference measurement values. In addition to the reference measurement values, it is necessary to know the line-to-neutral voltage of the faulted phase leg and the ratio of the impedance of the line from the distribution station to the fault point to the overall impedance of the entire looped ring, the latter being known in beforehand. In this manner, it is possible to update the admittance values $\underline{Y}_{0At}$ and $\underline{Y}_{0Bt}$ in conjunction with each identified ground fault along the looped ring after the fault point has been positively located. If the reference measurement values are taken from a ground fault measurement, the computation also needs the line-to-ground fault resistance value that can be computed as follows in a radial connection configuration using the above-given Eq. 8 of the leakage resistance:

$$\underline{Y}_{0At} = \frac{\Delta \underline{I}_{0A} - \Delta \left( \dfrac{\underline{U}_{vF}}{R_F} \dfrac{x_B}{l} \right)}{\Delta \underline{U}_0} \tag{24}$$

$$\underline{Y}_{0Bt} = \frac{\Delta \underline{I}_{0B} - \Delta \left( \dfrac{\underline{U}_{vF}}{R_F} \dfrac{x_A}{l} \right)}{\Delta \underline{U}_0} \tag{25}$$

When the admittances $\underline{Y}_{0At}$ and $\underline{Y}_{0Bt}$ are known the unsymmetry current components $\underline{I}_{0kA}$, $\underline{I}_{0kB}$ can be solved from Eqs. 14 and 15. A more accurate result is obtained if the computation of $\underline{I}_{0kA}$ and $\underline{I}_{0kB}$ is carried out using measurement values taken during an unfaulted state. The unsymmetry current components do not change when the zero-sequence voltage changes. Hence, these values can be used for fault location when the distance to fault is computed from Eqs. 17 and 18. These admittance values $\underline{Y}_{0At}$ and $\underline{Y}_{0Bt}$ are also utilized in the methods described later.

Generally, the sending ends connected into a looped ring are not the only sending ends of a network, but instead the distribution station also feeds other sending ends that in the examined case are sound. If the neutral of the network possibly has a Petersen coil connected thereto, the coil causes during a ground fault both an inductive zero-sequence current component and a resistive component representing the coil losses. The arc-suppression reactor may also have an additional resistor connected in parallel therewith that serves to assure a sufficiently large real component in the fault current for the proper function of the directional relay protection in the arc-suppressed network. Then, the zero-sequence current produced by the sound part of the network in combination with the possible neutral-to-ground impedance is divided between the sending ends connected in the looped ring in the mutual ratio of the impedances of the sending ends from the distribution station to the fault point. The combined line-to-ground admittance $\underline{Y}_{0c}$ of the sending ends and the admittances $\underline{Y}_{0At}$ and $\underline{Y}_{0Bt}$ can be determined using the methods described just above (see computation of fault distance from zero-sequence currents and zero-sequence voltage).

The zero-sequence current component caused by the sound part of the network (sound sending ends plus neutral-to-ground impedance) can be computed with the help of Eq. 16. The effect of the unsymmetry current components is relatively small and may even be eliminated entirely using the methods described just above (see computation of fault distance from zero-sequence currents and zero-sequence voltage). Then, the ground-fault current of the network can be computed as follows:

$$\underline{I}_e = \frac{\underline{U}_{vF}}{R_F} = \Sigma\underline{I}_{0b} - \underline{Y}_{0c}\underline{U}_0 - \underline{I}_{0k} = (\Sigma\underline{I}_{0A} + \Sigma\underline{I}_{0B}) - \underline{Y}_{0c}\underline{U}_0 - \underline{I}_{0k} \tag{26}$$

Herein, the contribution $\underline{I}_{eA}$ of sending end A to the ground-fault current is

$$\underline{I}_{eA} = \Sigma\underline{I}_{0A} - \underline{Y}_{0At}\,\underline{U}_0 - \underline{I}_{0kA} \tag{27}$$

and the contribution $\underline{I}_{eB}$ of sending end B is

$$\underline{I}_{eB} = \Sigma\underline{I}_{0B} - \underline{Y}_{0Bt}\,\underline{U}_0 - \underline{I}_{0kB} \tag{28}$$

Now, the fault distances $x_A$ and $x_B$ can be written as

$$\frac{x_A}{1} = \frac{\underline{I}_{eB}}{\underline{I}_e}, \ \frac{x_B}{1} = \frac{\underline{I}_{eA}}{\underline{I}_e}, \ \frac{x_A}{x_B} = \frac{\underline{I}_{eB}}{\underline{I}_{eA}} \tag{29}$$

The distances $x_A$, $x_B$ and 1 may be replaced by the corresponding longitudinal impedances of the line section, whereby the impedances are formed by the sum of the positive-sequence, negative-sequence and zero-sequence impedances of the line sections. The phasors of currents $\underline{I}_e$, $\underline{I}_{eA}$ and $\underline{I}_{eB}$ can be synchronized to the reference phase of the zero-sequence voltage, thus making it possible to divide the phasor in its real and reactive current components. Then it is even possible to determine the fault distance separately from both the real and the reactive current components. In the latter case, the line section impedances must be divided into their positive-sequence, negative-sequence and zero-sequence resistances and reactances. With these, the fault distance is obtained as a resistance or reactance ratio depending on whether the real or the reactive component of the ground fault current is used in the computations.

The latter method has a benefit over the earlier described method (wherein the ground fault distance is computed from the zero-sequence currents and the zero-sequence voltage) in that there is no need to compute the line-to-ground fault resistance in beforehand. As the latter method additionally uses comparison, wherein the fault current components of either sending end is compared with the summed ground fault current, the latter method provides higher accuracy than what is achievable with the help of Eqs. 17 and 18. The fault distance can be determined in three different ways, that is, using the summed zero-sequence current, the real component of the zero-sequence current or the reactive component thereof. This gives improved possibilities of estimating the order of error in the fault location. Additionally, in each fault location operation it is possible to obtain information on the ratio of longitudinal impedances as to how they are divided on either sides of the fault point along the ring-looped line. Furthermore, each fault location gives the ring-looped line a new "calibration point" whereat the division ratio of fault currents on the ring-looped line and, hence, also its impedance ratio are known. This information can be utilized in later faults, which means that the accuracy of fault location improves continuously with the use of the method in the determination of fault distances. When the computed fault point falls between two "calibration points", the accuracy of fault location can be improved by interpolation. This permits determination of the fault distance, particularly in homogeneous networks (comprising only overhead lines or ring-looped underground cables, respectively), without resorting to network data.

In a ring connection, a ground fault can be located by measuring the summed currents of the ring-looped sending ends during the fault at two different values of the neutral voltage, whereby the proportional distribution of the line-to-ground admittance change between the ring-looped sending ends can be computed. This change is proportional to the fault distance. The neutral voltage can be changed in a resonant-ground network by changing the tuning of the arc-suppression reactor. In both a resonant-ground and an isolated-neutral network, a change in the connection status also causes a change in the neutral voltage.

In the case of a high-impedance ground fault (e.g., a fallen tree), the fault resistance generally becomes smaller due to the fault current, whereby neutral voltage increases. Then, the fault location can be performed using the admittance method for the computations even if the neutral voltage of the network is not altered intentionally.

During a fault, the line-to-ground admittances of sending ends A and B configured into a looped ring can be computed as follows:

$$\underline{Y}_{0A} = \frac{\Delta \underline{I}_{0A}}{\Delta \underline{U}_0} = \frac{x_B}{l} \frac{1}{R_F} \frac{\Delta \underline{U}_{vF}}{\Delta \underline{U}_0} + \underline{Y}_{0At} = \frac{x_B}{l} \frac{1}{R_F} + \underline{Y}_{0At} \tag{30}$$

$$\underline{Y}_{0B} = \frac{\Delta \underline{I}_{0B}}{\Delta \underline{U}_0} = \frac{x_A}{l} \frac{1}{R_F} \frac{\Delta \underline{U}_{vF}}{\Delta \underline{U}_0} + Y0_{Bt} = \frac{x_A}{l} \frac{1}{R_F} + \underline{Y0}_{Bt} \tag{31}$$

The admittance of the entire looped ring can be written as a sum of its components. As a result of the fault, its value shows a change equal to the conductance added by the fault resistance. The value of the fault resistance can be computed from Eq. 32 below:

$$\underline{Y}_{0tot} = \underline{Y}_{0A} + \underline{Y}_{0B} = \frac{1}{R_F} + \underline{Y}_{0c} \tag{32}$$

Then, the fault distance along either line section connected to the sending ends can be computed from the real parts of the line-to-ground admittances computed from the measurement values:

$$\frac{x_A}{l} = \frac{\text{Re}(\underline{Y}_{0B})}{\text{Re}(\underline{Y}_{0tot})}, \frac{x_B}{l} = \frac{\text{Re}(\underline{Y}_{0A})}{\text{Re}(\underline{Y}_{0tot})}, \frac{x_A}{x_B} = \frac{\text{Re}(\underline{Y}_{0B})}{\text{Re}(\underline{Y}_{0A})}, \tag{33}$$

If the admittances $\underline{Y}_{0At}$, $\underline{Y}_{0Bt}$ and $\underline{Y}_{0c}$ are known (Eqs. 21-23), the fault distances can be determined directly from the differences $\underline{Y}_{0A}$- $\underline{Y}_{0At}$, $\underline{Y}_{0B}$ - $\underline{Y}_{0Bt}$ and $\underline{Y}_{0tot}$ - $\underline{Y}_{0c}$.

As a variation of the earlier described method (computation of ground fault distance from the change of the line-to-ground admittance), the fault distance may also be computed with the help of the distribution ratio of the fault resistance on both sides of the fault. Using the measurement values obtained in a looped ring configuration, the fault resistance can be computed with the help of Eq. 34. The fault resistance is computed form Eq. 34 using separately each one of the line-to-neutral voltages measured during the fault. The result is a complex value having a positive sign of its real part for a faulted phase leg and a negative sign for an sound phase leg. Accordingly, the faulted phase leg is the one having the largest magnitude of its real part as computed from Eq. 34. The real part thus obtained also gives the magnitude of the fault resistance:

$$R_F = \frac{\underline{U}_{vF}}{(\underline{I}_{0A} + \underline{I}_{0B}) - \underline{Y}_{0c}\underline{U}_0 - (\underline{I}_{0kA} + \underline{I}_{0kB})} \tag{34}$$

If the zero-sequence currents of the looped ring configuration are known for the unfaulted state, the fault resistance can be computed from Eq. 35 below.

$$R_F = \frac{\underline{U}_{vF}}{\Delta \underline{I}_{0b} - \underline{Y}_{0c}\Delta \underline{U}_0} \tag{35}$$

The conductance represented by the fault resistance is divided in an inverse ratio between the looped sending ends. The "apparent" fault resistances at the sending ends A and B can be computed as follows:.

$$R_{FA} = \frac{\underline{U}_{vF}}{\underline{I}_{0A} - \underline{Y}_{0At}\underline{U}_0 - \underline{I}_{0kA}} \tag{36}$$

$$R_{FB} = \frac{\underline{U}_{vF}}{\underline{I}_{0B} - \underline{Y}_{0Bt}\underline{U}_0 - \underline{I}_{0kB}} \tag{37}$$

The "apparent" fault resistances at the sending ends A and B may also be computed from Eq. 35 with the help of the changes occurring in the zero-sequence current and voltage during the fault provided that the zero-sequence currents of the ring-looped configuration have been measured in beforehand during an unfaulted state. Then, the ratios of the fault distances on both sides of the looped ring can be determined according to Eq. 38 below:

$$\frac{x_A}{1} = \frac{Re\left(\frac{1}{R_{FB}}\right)}{Re\left(\frac{1}{R_F}\right)}, \qquad \frac{x_B}{1} = \frac{Re\left(\frac{1}{R_{FA}}\right)}{Re\left(\frac{1}{R_F}\right)}, \qquad \frac{x_A}{x_B} = \frac{Re\left(\frac{1}{R_{FB}}\right)}{Re\left(\frac{1}{R_{FA}}\right)} \tag{38}$$

In practice, also the positive-sequence, negative-sequence and zero-sequence impedances of the line sections affect the proportional distribution of the fault current component caused by the fault resistance. The fault distances $x_A$, $x_B$ and 1 can be converted into corresponding impedances with help of network data. Then, the distance expressed in meters is equal to the sum of the positive-sequence, negative-sequence and zero-sequence impedances of the concerned line section. The accuracy of fault distance computation can be improved with time by virtue of systematically using the methods according to the invention in fault location in preplanned looped ring configurations. If the line-to-ground admittance ratio is known for two cases of a ground fault at two different locations, the location of a new ground fault can be determined by interpolation. Hence, the accuracy of fault location computations will improve gradually by means of using the methods according to the invention for fault location.

The computation of the distance to a ground fault utilizes measurement information obtained from numerical protective relays. The computation itself is suitably carried out in the computer environment of the network control room, whereby such information as network data is conveniently possible. On the other hand, the network operation support system has realtime access to the information on the connection status of the network. Hence, in combination with the above-described detection methods of high-impedance ground faults, the invention provides a computational method for the indication, location and distance determination of high-impedance ground faults.

The above-described computational methods can be utilized even at a higher accuracy and efficiency for ground fault location if the sending ends are continuously operated in a ring configuration. The ring may be opened automatically for measurements, e.g., with the help of a device situated at a disconnector station equipped with measurement means of the neutral voltage. Such a device of the disconnector station can also perform reclosure of the disconnector in a self-contained manner after the network status has returned normal, whereby the communications to the disconnector station are not necessarily needed. This arrangement eliminates time delay otherwise needed for ring connections and the fault location computation can be performed simply with the help of measurement values (that is, the zero-sequence voltages and the summed currents of the ring-looped sending ends) recorded prior to the fault and during the fault. The methods disclosed herein are applicable as such to this kind of situation. Obviously, the fault resistance can be computed directly with the help of Eq. 35. Thereafter, any method known in the art can be used. The effect of capacitance unsymmetry can be readily eliminated of the changes occurring in the summed currents of the ring-looped sending ends are utilized. The fault distances can be solved from Eqs. 39 and 40 given below:

$$\Delta\underline{I}_{0A} = \frac{\underline{U}_{vF}}{R_F}\frac{x_B}{1} + \underline{Y}_{0At}\Delta\underline{U}_0 \tag{39}$$

$$\Delta\underline{I}_{0B} = \frac{\underline{U}_{vF}}{R_F}\frac{x_A}{1} + \underline{Y}_{0Bt}\Delta\underline{U}_0 \tag{40}$$

The fault distance computation requires that the faulted sending end is connected into a looped ring with some other sending end. Herein, the operating delay of a remote-controlled disconnector is typically in the order of a few tens of seconds. During this time the fault point is energized. The fulfillment of safe grounding voltage regulations can be verified by computing the fault resistance using, e.g., the above-described methods that are suited for the detection of a high-resistance ground fault. Generally, the method is not limited by grounding voltage regulations when used for the detection of ground faults that occur at such a line-to-ground fault impedance which are typically encountered in the use of the methods according to the present invention. In a resonant-ground network, the residual current is so low that the network can be safely operated for the time required to configure and release the looped-ring connection. With more advanced communications facilities, also the time needed for the operation of the remote-controlled disconnector can be substantially reduced.

As a result of the computation, the fault can be located along the bulk power-transmission section of the looped ring configuration. If the fault occurs on a long lateral, it must be located using other techniques such as fault locators.

**References**

[Leh92] : Lehtonen M. : Transient analysis for ground fault distance estimation in electrical distribution networks. Technical Research Centre of Finland, Publication no. 115, Doctoral thesis of Tampere University of Technology, Espoo, 1992, 182 pp + app.

[Win93] : Winter K. : Swedish distribution networks - a new methode for earth fault protection in cable and overhead systems. Developments in Power System Protection, DPSP'93, 3 pp.

(Lei97) : Leitloff V. et.al. : Detection of resistive single-phase earth fault in a compensated power-distribution system. ETEP Vol. 7, No 1, January/February 1997.

(Lei94) : Leitloff V. et.al. : Messung der Parameter eines kompensierten Netzes durch Injektion eines Stromes in den Sternpunkt. Elektrizitätswirtschaft, Jg. 93 (1994), Heft 22.

(Sch94) : Schäfer H.-D. : Erhöhung der Verlagerungsspannung in Mittelspannungs-Kabelnetze mit Erdschlusskompensation. Elektrizitätswirtschaft, Jg. 93 (1994), Heft 21.

[Nik98]: Nikander, A. et. al.: Methods for earth fault identification and distance estimation in a compensated medium voltage distribution network. Energy Management and Power Delivery, EMPD'98, p. 595-600.

**Claims**

1. Method for computational determination of ground fault distance in an electric power transmission network connected into a ring configuration utilizing numerical measurement data obtained by means of a multifunction protective relay, whereby in the method the following steps are carried out:

   - a fault is detected and a faulted sending end (6) is identified,
   - a fault resistance to ground is computed,
   - the faulted sending end (6) is connected to form a looped ring with one of the sound sending ends (5),
   - zero-sequence voltage, line-to-neutral voltages and zero-sequence currents of the sending ends connected into a looped ring are measured, plus one line-to-line voltage for phasor synchronization,
   - the looped ring is released after the measurements,
   - phases of the measurement signals are referenced to the line-to-line voltage and frequency components different from the fundamental frequency are filtered away, whereupon the RMS values of the signals are computed based on the thus obtained fundamental-frequency components of the signals, and
   - a fault distance is computed, whereupon the faulted line section can be disconnected,

   characterized in that the fault detection is carried out performing the steps of:

- computing for the values of the line-to-ground admittance, $Y_{tEi}$, and the degree of unsymmetry, $|k_i|$, of each sending end a reference value, $Y_{tEiref}$ and $|k_{iref}|$, on the basis of measurement information obtained by means of an artificial deviation of the neutral voltage performed in a reference connection state,

- storing in a memory as reference values the values of the line-to ground admittance, $Y_{tEiref}$, and the degree of unsymmetry, $|k_{iref}|$, of each sending end, i, as well as the normal-connection status values of the zero-sequence voltage $U_{0ref}$, and the zero-sequence currents, $I_{0refi}$, of the sending ends and the zero-sequence current, $I_{0refs}$, of the feeding power source,

- monitoring the zero-sequence voltage, $U_0$, at least essentially continuously and, if said zero-sequence voltage, $U_0$, changes by more than a predetermined limit difference, $\Delta U_{0as}$, computing for each one of the sending ends, i, new values of line-to-ground admittance, $Y_{tEi}$, and degree of unsymmetry, $|k_i|$,

- comparing the most recently computed values of the line-to-ground admittance, $Y_{tEi}$, with the reference values, $Y_{tEiref}$, and determining whether the difference therebetween exceeds the inaccuracy ($\Delta Y_{tEi}$) of the measurement technique used,

- if the comparison gives a value greater than said measurement inaccuracy, $\Delta Y_{tEi}$, checking on the basis of the change in the entire network's summed line-to-ground admittance, which is computable for instance from zero-sequence current of the feeding power source, whether a change has occurred in the connection status of the network and, if so, storing the most recently measured values of the line-to-ground admittance, $Y_{tEi}$, and degree of unsymmetry, $|k_i|$, as new reference values, while, if no change has occurred in the network connection status, detecting a ground fault, and

- when necessary, comparing the computed degrees of unsymmetry of the sending ends, i, with the stored reference values, $|k_{iref}|$, and, if the change of the computed degree of unsymmetry exceeds said predetermined limit, $|\Delta k_i|$, of change, defining the monitored sending end to be affected by a high-impedance, single-phase ground fault.

**2.** Method according to claim 1, **characterized in that** the fault resistance is computed using Eqs. 5 and 8 of the method description.

**3.** Method according to any one of the foregoing claims, **characterized in that** the faulted sending end (6) is allowed to trip.

**4.** Method according to any one of foregoing claim, **characterized in that** the fault distance is computed on the basis of said zero-sequence current and voltage using, Eqs. 14-25 of the method description.

**5.** Method according to claim 1, 2, or 3, **characterized in that** the fault distance is computed on the basis of the sending-end distribution ratio of the line-to-ground fault current using Eqs. 26-29 of the method description.

**6.** Method according to claim 1, 2 or 3, **characterized in that** the fault distance is computed on the basis of the change in the line-to-ground admittance values using Eqs. 30-33 of the method description.

**7.** Method according to claim 1, 2 or 3, **characterized in that** the fault distance is computed on the basis of the line-to-ground fault resistance value using Eqs. 34-38 of the method description.

**8.** Method according to any one of foregoing claim, **characterized in that** the maximum time to fault location is determined as the sum of the control delay of the faulted line disconnector and the time required for measurement of fault variables.

**Patentansprüche**

**1.** Verfahren zur rechengestützten Ermittlung der Entfernung eines Erdschlusses in einem Übertragungsnetz elektrischer Energie, welches in einer Ringstruktur verbunden ist, unter Verwendung numerischer Messdaten, erhalten mittels eines Multifunktions-Schutzrelais, wobei bei dem Verfahren die folgenden Schritte durchgeführt werden:

- ein Fehler wird erfasst und der fehlerbehaftete Abgang (6) wird identifiziert,
- der Fehlerwiderstand gegen Erde wird berechnet,
- der fehlerhafte Abgang (6) wird in Form einer Ringschleife mit einem der gesunden Abgänge (5) verbunden
- die Nullspannung, die Strangspannungen und die Nullströme der in der Schleife verbundenen Abgänge werden gemessen, zusätzlich eine Außenleiterspannung zur Phasensynchronisation,

- nach den Messungen wird die Schleife geöffnet,
- die Phasen der Messsignale werden auf die Außenleiterspannung bezogen und Frequenzen, die verschieden von der Grundfrequenz sind, werden ausgefiltert, woraufhin die Effektivwerte der Signale auf der Basis der erhaltenen Grundfrequenzanteile dieser Signale berechnet werden, und
- der Fehlerabstand wird berechnet, wobei der fehlerhafte Leitungsabschnitt abgeschaltet werden kann,

**gekennzeichnet dadurch, dass** die Fehlererkennung in folgenden Schritten ausgeführt wird:

- Berechnung eines Referenzwertes $Y_{tEi\,ref}$ und $|k_{i\,ref}|$ für die Werte der Leiter-Erde-Admittanz $Y_{tEi}$ und des Grades der Unsymmetrie $|k_i|$ für jeden Abgang auf der Basis einer Messinformation, die erhalten wird mittels einer künstlichen Abweichung der Nullleiterspannung, die in einem Referenzverbindungsstatus durchgeführt wird,
- Speicherung der Werte der Leiter-Erde-Admittanz $Y_{tEi\,ref}$ und des Grades der Unsymmetrie $|k_{i\,ref}|$ für jeden Abgang i als Referenzwerte in einem Speicher, sowie der Werte des normalen Anschlussstatus der Nullspannung $U_{0\,ref}$ und der Nullströme $I_{0\,ref\,i}$ der Abgänge und der Nullstrom $I_{0\,ref\,s}$ der speisenden Energiequelle,
- zumindest im wesentlichen kontinuierliche Überwachung der Nullspannung $U_0$ und, wenn sich die Nullspannung Uo um mehr als eine vorgegebene Grenzdifferenz $\Delta U_{0as}$ ändert, Berechnung neuer Werte der Leiter-Erde-Admittanz $Y_{tEi}$ und des Grades der Unsymmetrie $|k_i|$ für jeden Abgang i,
- Vergleich der zuletzt berechneten Werte der Leiter-Erde-Admittanz $Y_{tEi}$ mit den Referenzwerten $Y_{tEi\,ref}$ und Feststellung, ob die Differenz zwischen ihnen eine Ungenauigkeit $\Delta Y_{tEi}$ der verwendeten Messtechnik überschreitet,
- Wenn der Vergleich einen Wert größer als die Messungenauigkeit $\Delta Y_{tEi}$ ergibt, Ermittlung auf der Grundlage der Veränderung der summierten Leiter-Erde-Admittanz des gesamten Netzes, die beispielsweise aus dem Nullstrom der speisenden Energiequelle berechenbar ist, ob eine Veränderung im Anschlussstatus des Netzes aufgetreten ist, wenn dies so ist, Speicherung der zuletzt gemessenen Werte der Leiter-Erde-Admittanz $Y_{tEi}$ und des Grades der Unsymmetrie $|k_i|$ als neue Referenzwerte, wenn hingegen keine Veränderung des Anschlussstatus des Netzes aufgetreten ist, Erfassen eines Erdschlusses, und
- wenn notwendig, Vergleich der berechneten Grade der Unsymmetrie der Abgänge i mit den gespeicherten Referenzwerten $|k_{i\,ref}|$, und, wenn die Änderung des berechneten Grades der Unsymmetrie die vorbestimmte Grenze der Änderung $|\Delta k_i|$ überschreitet, definieren, dass der überwachte Abgang von einem hochohmigen einphasigen Erdschluss betroffen ist.

2. Verfahren nach Anspruch 1, **gekennzeichnet dadurch, dass** der Fehlerwiderstand durch Verwendung der Gleichungen 5 und 8 der Verfahrensbeschreibung berechnet wird.

3. Verfahren nach irgendeinem der vorhergehenden Ansprüche, **gekennzeichnet dadurch, dass** der fehlerhafte Abgang (6) getrennt werden darf.

4. Verfahren nach irgendeinem der vorhergehenden Ansprüche, **gekennzeichnet dadurch, dass** der Fehlerabstand auf der Grundlage des genannten Nullstromes und der Spannung durch Verwendung der Gleichungen 14-25 der Verfahrensbeschreibung berechnet wird.

5. Verfahren nach den Ansprüchen 1, 2 oder 3, **gekennzeichnet dadurch, dass** der Fehlerabstand auf der Grundlage des Verteilungsverhältnisses des Erdschlussstromes an den Abgängen unter Verwendung der Gleichungen 26-29 der Verfahrensbeschreibung berechnet wird.

6. Verfahren nach den Ansprüchen 1, 2 oder 3, **gekennzeichnet dadurch, dass** der Fehlerabstand auf der Grundlage der Veränderung der Werte der Leiter-Erde-Admittanz unter Verwendung der Gleichungen 30-33 der Verfahrensbeschreibung berechnet wird.

7. Verfahren nach den Ansprüchen 1, 2 oder 3, **gekennzeichnet dadurch, dass** der Fehlerabstand auf der Basis des Wertes des Leiter-Erde-Fehlerwiderstandes unter Verwendung der Gleichungen 34-38 der Verfahrensbeschreibung berechnet wird.

8. Verfahren nach irgendeinem der vorhergehenden Ansprüche, **gekennzeichnet dadurch, dass** die maximale Zeit zur Fehlerlokalisierung bestimmt wird als die Summe aus der Regelungsverzögerung des Trennschalters der fehlerhaften Leitung und der für die Messung der Fehlervariablen erforderlichen Zeit.

**Revendications**

1. Procédé de détermination par calcul de la distance du défaut à la terre dans un réseau de distribution d'énergie connecté selon une configuration en anneau en utilisant des données de mesures numériques obtenues au moyen d'un relais de protection multifonctions, dans lequel sont exécutées les étapes suivante :

   - un défaut est détecté et une extrémité émettrice en défaut (6) est identifié,
   - une résistance de défaut à la terre est calculée,
   - l'extrémité émettrice en défaut (6) est connecté pour former un anneau bouclé avec une des extrémités émettrice saines (5),
   - la tension homopolaire, les tensions phase-neutre et les courants homopolaires des extrémités émettrices connectées dans un anneau bouclé sont mesurés, plus une tension composée pour synchronisation de phaseur,
   - l'anneau bouclé est libéré après les mesures,
   - des phases des signaux de mesure sont référencées à la tension composée et des composantes de fréquences différentes de la fréquence fondamentale sont éliminées par filtrage, après quoi les valeurs efficaces des signaux sont calculées sur la base des composantes de fréquence fondamentale des signaux ainsi obtenues, et
   - une distance de défaut est calculée, après quoi la section de ligne défectueuse peut être sectionnée,

   **caractérisée en ce que** la détection de défaut est exécutée en effectuant les étapes consistant à :

   - calculer pour les valeurs d'admittance phase-terre, $Y_{tEi}$, et le degré de non-symétrie, $|k_i|$, de chaque extrémité émettant une valeur de référence $Y_{tEiref}$ et $|k_{iref}|$, sur la base d'informations de mesure obtenues au moyen d'une déviation artificielle de la tension de neutre effectuée dans un état de connexion de référence,
   - mémoriser dans une mémoire comme valeurs de référence les valeurs de l'admittance phase-terre, $Y_{tEiref}$, et du degré de non-symétrie, $|k_{iref}|$, de chaque extrémité émettrice, i, ainsi que les valeurs d'état de connexion normale de la tension homopolaire, $U_{0ref}$, et les courants homopolaires, $I_{0refi}$, des extrémités émettrice et le courant homopolaire, $I_{0refs}$, de la source d'énergie d'alimentation,
   - surveiller la tension homopolaire, $U_0$, au moins sensiblement de manière continue et, si ladite tension homopolaire, $U_{0as}$, varie de plus d'une différence limite prédéterminée, $\Delta U_{0as}$, calculer pour chacune des extrémité émettrice, i, de nouvelles valeurs d'admittance phase-terre, $Y_{tEi}$, et de degré de non-symétrie, $|k_i|$,
   - comparer les valeurs les plus récemment calculées de l'admittance phase-terre, $Y_{tEi}$, avec les valeurs de référence, $Y_{tEiref}$, et déterminer si la différence entre celles-ci dépasse l'incertitude, $\Delta Y_{tEi}$, de la technique de mesure utilisée,
   - si la comparaison donne une valeur plus grande que ladite incertitude de mesure, $\Delta Y_{tEi}$, vérifier sur la base de la variation de l'admittance phase-terre totalisée de tout le réseau, qui est calculable par exemple à partir du courant homopolaire de la source d'énergie d'alimentation, si une variation s'est produite dans l'état de connexion du réseau et, si oui, mémoriser les valeurs les plus récemment mesurées de l'admittance phase-terre, $Y_{tEi}$, et du degré de non-symétrie, $|k_i|$, comme nouvelles valeurs de référence, et, si aucune variation ne s'est produite dans l'état de connexion du réseau, détecter un défaut à la terre, et
   - si nécessaire, comparer les degrés calculés de non-symétrie des extrémités émettrices, i, avec les valeurs de référence mémorisées, $|k_{iref}|$, et, si la variation du degré calculé de non-symétrie dépasse ladite limite prédéterminée, $|\Delta k_i|$, de variation, définir l'extrémité émettrice surveillée comme étant affectée par un défaut à la terre monophasé de haute impédance.

2. Procédé selon la revendication 1, **caractérisé en ce que** la résistance de défaut est calculée en utilisant les équations 5 et 8 de la description de procédé.

3. Procédé selon l'une quelconque des revendications précédentes, **caractérisé en ce que** l'extrémité émettrice en défaut (6) est autorisée à déclencher.

4. Procédé selon l'une quelconque des revendications précédentes, **caractérisé en ce que** la distance du défaut est calculée sur la base desdits courant et tension homopolaires en utilisant les équations 14-25 de la description de procédé.

5. Procédé selon la revendication 1, 2 ou 3, **caractérisé en ce que** la distance du défaut est calculée sur la base de rapport de distribution d'extrémité émettrice du courant de défaut phase-terre en utilisant les équations 26-29 de la description de procédé.

6. Procédé selon la revendication 1, 2 ou 3, **caractérisé en ce que** la distance du défaut est calculée sur la base de la variation des valeurs d'admittance phase-terre en utilisant les équations 30-33 de la description de procédé.

7. Procédé selon la revendication 1, 2 ou 3, **caractérisé en ce que** la distance du défaut est calculée sur la base de la valeur de résistance de défaut phase-terre en utilisant les équations 34-38 de la description de procédé.

8. Procédé selon l'une quelconque des revendications précédentes, **caractérisé en ce que** la durée maximum à la position de défaut est déterminée comme la somme du retard de commande du sectionneur de ligne en défaut et du temps nécessaire pour la mesure de variables de défaut.

Fig. 1

20 kV

Network sending ends

1

10

Main transformer

11

2

3

4

Ring-looped
sending ends 5

110/21 kV

Sending
end A

Ring length: 1

6

12

Sending
end B

14

RF

Distance to fault point:
Sending end A: $x_A$
Sending end B: $x_B$

13 Distance to sending end i:
Sending end A: $d_{Ai}$
Sending end B: $d_{Bi}$

# Fig. 2

EP 1 089 081 B1